(19) Europäisches Patentamt / European Patent Office / Office européen des brevets

(11) **EP 2 588 869 B1**

(12) **EUROPÄISCHE PATENTSCHRIFT**

(45) Veröffentlichungstag und Bekanntmachung des Hinweises auf die Patenterteilung:
**09.09.2015 Patentblatt 2015/37**

(21) Anmeldenummer: **11741140.5**

(22) Anmeldetag: **01.07.2011**

(51) Int Cl.:
***G01R 1/20*** *(2006.01)*

(86) Internationale Anmeldenummer:
**PCT/EP2011/061141**

(87) Internationale Veröffentlichungsnummer:
**WO 2012/001157 (05.01.2012 Gazette 2012/01)**

(54) **STROMSENSOR**

CURRENT SENSOR

DÉTECTEUR DE COURANT

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **29.03.2011 DE 102011006377**
**01.07.2010 DE 102010030805**

(43) Veröffentlichungstag der Anmeldung:
**08.05.2013 Patentblatt 2013/19**

(73) Patentinhaber: **Continental Teves AG & Co. oHG 60488 Frankfurt (DE)**

(72) Erfinder:
• **DIETZ, Timo**
**65239 Hochheim (DE)**
• **JÖCKEL, Wolfgang**
**36129 Gersfeld (DE)**
• **RINK, Klaus**
**Rodenbach 63517 (DE)**
• **GAERTNER, Thomas**
**10247 Berlin (DE)**
• **GRASSHOFF, Helge**
**93053 Regensburg (DE)**

(56) Entgegenhaltungen:
**EP-A1- 0 581 993     WO-A1-2008/071722**
**DE-C1- 10 223 977     US-A1- 2006 250 153**

**Beschreibung**

Die Erfindung betrifft einen Stromsensor gemäß Oberbegriff von Anspruch 1 sowie die Verwendung des Stromsensors in Kraftfahrzeugen.

Stromsensoren sind aus folgenden Veröffentlichungen bekannt: WO 2008/071722 AI , US 2006/250153 und DE 102 23 977 C1.

In Kraftfahrzeugen werden heute an vielen Stellen Strommessungen durchgeführt. Diese Strommessungen sind beispielsweise in Regelkreise eingebunden, dienen der Überwachung von Grenzwerten oder werden zum Messen des Entlade-, bzw. Ladestroms einer Batterie eingesetzt. Bei letzterem Einsatzgebiet wird unter anderem der Ladezustand der Batterie ermittelt. Außerdem werden über das Monitoring bzw. die Überwachung des Innenwiderstandes der Batterie Rückschlüsse auf den Zustand der Batterie gezogen. Hierzu gehören Alter und Kapazität der Batterie.

Aufgrund der Suche nach neuen Antriebskonzepten unter Nutzung von erneuerbaren Energien konzentrieren sich zahlreiche Entwicklungen auf Elektro - und Hybridantriebe. Hier gewinnt die Erfassung des Ladezustands und des Gesamtzustandes der Batterie weiter an Bedeutung. Dabei muss der Strom und die Spannung der Batterie gemessen werden. Die Batteriespannungen liegen hier bei bis zu 1000V und die Entladeströme bei bis zu 600A. Der Dynamikbereich der zu messenden Ströme erstreckt sich beispielsweise von 10mA bis 1000A, also Faktor $1 \cdot 10^{-5}$. Die Genauigkeit soll häufig < 1% bezogen auf den jeweiligen Messwert betragen. Damit keine zu hohe Verlustleistung entsteht, ist der Wert des Shuntwiderstandes auf maximal $100\mu\Omega$ begrenzt.

Am weitesten verbreitet ist die Strommessung anhand der Messung der Spannung über einem, in den Stromkreis geschalteten, ohmschen Widerstand (Shunt). Dabei ist es allerdings häufig schwierig den geforderten Dynamikbereich mit der geforderten Genauigkeit abzudecken. Beispielsweise fällt bei einem Strom von 10mA am $100\mu\Omega$ Wi-derstand eine Spannung von $1\mu$V ab, die auf 1% genau gemessen werden muss. Bei 1000A fallen 100mV ab, die ebenfalls sehr genau gemessen werden müssen. Hierzu werden zum einen hochauflösende, genaue AD-Wandler benötigt, zum anderen können sich aufgrund der sehr geringen Spannungen und der störintensiven Automotive-Umgebung Probleme bzgl. der EMV-Festigkeit ergeben. Das treibt die Kosten hoch.

Der Erfindung liegt die Aufgabe zu Grunde, einen Stromsensor vorzuschlagen, der relativ kostengünstig einsetzbar ist, insbesondere bei einem relativ großen Messbereich bzw. bei einem relativ großen Dynamikumfang des zu messenden Stroms.

Diese Aufgabe wird erfindungsgemäß gelöst durch den Stromsensor gemäß Anspruch 1.

Der Erfindung liegt insbesondere der Gedanke zu Grunde, dass das Widerstandselement so ausgebildet ist, dass zumindest innerhalb eines definierten Messbereichs des Stromsensors der elektrische Widerstand des Widerstandselements abnimmt, wenn der Strom durch das Widerstandselement zunimmt und/oder dass der elektrische Widerstand des Widerstandselements zunimmt, wenn der Strom durch das Widerstandselement abnimmt.

Bevorzugt liegt der Ausbildung des Stromsensors die Anforderung zu Grunde, dass die geforderte Auflösung von deltaI/deltaBit bis auf einen Proportionalitätsfaktor - kleiner ist als der maximale Messfehler e. Dabei ist deltaI die Änderung des zu messenden Stroms durch das wenigstens eine Widerstandselement und deltaBit das Messauflösungsquantum definiert durch einen nachgeschalteten Analog-Digital-Wandler. Der maximale Messfehler e soll dabei konstant bzw. jederzeit höchstens p% vom jeweiligen Messwert betragen, beispielsweise unter 1% bleiben. Im Folgenden wird aus diesen Anforderungen anhand der folgenden Gleichungen beispielhaft ein gewünschter bzw. idealer Zusammenhang zwischen Messspannung und Messstrom theoretisch hergeleitet:

geforderte Auflösung:

$$\frac{\Delta I}{\Delta D} = p\% \cdot I = p\% \cdot I_{\max} \cdot \frac{D}{2^n - 1} \quad \Rightarrow (1): \Delta I = p\% \cdot I_{\max} \cdot \frac{D}{2^n - 1} \Delta D$$

$$(2): \frac{D}{(2^n - 1)} = \frac{U_{AD}}{U_{AD\,\max}} \; ; (3): \Delta D = \frac{\Delta U_{AD}}{U_{AD\,\max}} \cdot (2^n - 1)$$

$$(2),(3) \rightarrow (1) \Rightarrow (4): \Delta I = p\% \cdot I_{\max} \cdot \frac{U_{AD}}{U_{AD\,\max}^2} \cdot (2^n - 1) \cdot \Delta U_{AD}$$

$$(4) \xrightarrow{\Delta \to \partial} (5) : \partial I = p\% \cdot I_{max} \cdot \frac{U_{AD}}{U_{AD\,max}^{2}} \cdot \left(2^{n} - 1\right) \partial U_{AD}$$

$$(6) : I = p\% \cdot \frac{I_{max}}{U_{AD\,max}^{2}} \cdot \left(2^{n} - 1\right) \int_{0}^{U_{sense}} U_{AD} \ \partial U_{AD}$$

$$(7) : I = p\% \cdot \frac{I_{max}}{U_{AD\,max}^{2}} \cdot \frac{2^{n} - 1}{2} \cdot U_{sense}^{2} = p\% \cdot k \cdot U_{sense}^{2}$$

$$(8) : U_{sense} = \sqrt{\frac{I}{p\% \cdot k}}$$

mit:

$I_{max}$ : maximaler Messstrom
$n$ : Bitbreite AD-Wandler
$D$ : AD gewandelter Messwert [LSB]
$U_{AD}$ : AD-Wandler Eingangsspannung
$U_{AD\,max}$ : maximaler AD Wandlungsbereich
$U_{sense}$ : aktuelle Messspannung

Aus der zweckmäßigen Forderung einer prozentual konstanten Auflösung ergibt sich idealerweise ein zumindest quadratischer Zusammenhang zwischen Messspannung und zu messendem Strom, welcher bevorzugt auch durch eine antiproportionale Funktion bzw. eine 1/x-Funktion zwischen Messspannung und Messstrom angenähert werden kann, durch eine entsprechende Auslegung des Widerstandselements.

Der Stromsensor ist vorzugsweise so ausgebildet, dass die prozentuale Auflösung der Strommessung bezogen auf den aktuellen Wert des Stroms bzw. den aktuellen Messstrom durch das Widerstandselement zumindest über den definierten Messbereich des Stromsensors im Wesentlichen konstant bleibt.

Der Stromsensor umfasst bevorzugt mindestens einen Regelkreis, mit welchem die Spannung über dem Widerstandselement auf einen definierten Referenzspannungswert eingeregelt wird, zumindest innerhalb eine definierten Messbereichs. Insbesondere beträgt dabei der definierte Referenzspannungswert mindestens 1 mV, besonders bevorzugt wenigstens 100mV. Solch ein bevorzugter Referenzspannungswert ist gegenüber dem Spannungswert über einem Shunt bei geringen Strömen deutlich störfester, da die Spannung über einem Shunt üblicherweise nur einen Wert im µV-Bereich aufweist.

Vorzugsweise ist der Stromsensor so ausgebildet, dass die definierte Referenzspannung zur Messbereichserweiterung einstellbar ist.

Der Stromsensor weist zur Bereitstellung der wenigstens einen Referenzspannung zweckmäßigerweise zumindest eine Referenzspannungsquelle auf.

Das Widerstandselement umfasst vorzugsweise mindestens ein Transistorelement, insbesondere wenigstens einen Feld-Effekt-Transistor, besonders bevorzugt zumindest einen MOSFET. Zur Messung des durch das Widerstandselement fließenden Stroms wird zweckmäßigerweise die Gate-Source-Spannung bzw. Basis-Emitter-Spannung an dem Transistorelement erfasst.

Der definierte Messbereich des Messstroms umfasst vorzugsweise mindestens vier Zehnerpotenzen, insbesondere wenigstens fünf Zehnerpotenzen.

Bei geregelter Spannung über dem Widerstandselement ist vorzugsweise der Widerstandswert des Widerstandselements im Wesentlichen abhängig von 1 durch den Wert des Stroms durch das Widerstandselement oder im Wesentlichen abhängig von 1 durch die Wurzel aus dem Wert des Stroms durch das Widerstandselement.

Das wenigstens eine Widerstandselement umfasst vorzugsweise zwei oder mehr parallel geschaltete Teilwiderstandselemente, welche zu- und/oder abschaltbar ausgebildet sind zur Messbereichserweiterung, wobei diese Teilwiderstandselemente insbesondere in den Regelkreis integriert sind.

Es ist bevorzugt, dass der Stromsensor zumindest ein Temperaturmesselement aufweist, welches die Temperatur des wenigstens einen Widerstandselements erfasst, wobei diese Temperatur bei der Messung des durch das

mindestens eine Widerstandelement fließenden Stroms berücksichtigt wird, insbesondere durch eine Berechnung in wenigstens einer Signalverarbeitungseinheit des Stromsensors.

Es ist zweckmäßig, dass der Stromsensor einen ersten und einen zweiten Regelkreis umfasst, mit welchen jeweils die Spannung über einem Widerstandelement auf einen definierten Referenzspannungswert eingeregelt wird, zumindest innerhalb eines definierten Messbereichs, wobei das Widerstandelement des ersten Regelkreises von dem zu messenden Strom mit einer ersten definierten Richtung durchflossen werden kann und das Widerstandelement des zweiten Regelkreises von dem zu messenden Strom mit einer zweiten, zur ersten Richtung entgegengesetzten Richtung durchflossen werden kann und der zu messende Strom je nach Stromrichtung mittels des ersten Regelkreises oder mittels des zweiten Regelkreises erfasst und gemessen wird. Die Referenzspannungswerte des ersten und zweiten Regelkreises sind insbesondere unterschiedlich einstellbar.

Es ist bevorzugt, dass die Widerstandelemente des ersten und zweiten Regelkreises als zwei zueinander komplementär ausgebildete Feldeffekttransistoren ausgebildet sind und/oder dass die Widerstandelemente des ersten und zweiten Regelkreises parallel geschaltet sind und dabei der Drainanschluss oder Kollektoranschluss des einen Widerstandelements jeweils mit dem Sourceanschluss oder Emitteranschluss des anderen Widerstandelements verbunden ist, insbesondere wechselseitig.

Dem wenigstens einen Widerstandelement ist vorzugsweise zumindest ein SenseFET zugeordnet, welcher mit einem Analog-Digital-Wandler verbunden ist, wobei mittels des SenseFETs der Strom durch das Widerstandelement bestimmt wird.

Zumindest der SenseFET und das zugeordnete Widerstandelement sind zweckmäßigerweise gemeinsam auf einem Chip ausgebildet.

Besonders bevorzugt ist die Gate-Source-Spannung bzw. Basis-Emitter-Spannung des SenseFETs gleich der Gate-Source-Spannung bzw. Basis-Emitter-Spannung des zugeordneten Widerstandelements ausgeprägt.

Zweckmäßigerweise weist der Quotient aus dem Wert des Drain-Source-Widerstands bzw. Kollektor-Emitter-Widerstands des SenseFETs zu dem Wert des Drain-Source-Widerstands bzw. Kollektor-Emitter-Widerstands des zugeordneten Widerstandelements einen definierten Wert auf. Insbesondere ist eine Referenzspannungsquelle oder Referenzstromquelle mit dem SenseFET verbunden, wodurch der Temperatureinfluss der Strommessung im Wesentlichen unterdrückt werden kann.

Unter einer Auflösung wird vorzugsweise eine definierte Mindestmessgenauigkeit verstanden.

Zweckmäßigerweise umfasst der wenigstens eine Regelkreis mindestens einen Verstärker als Stellglied.

Das wenigstens eine Widerstandelement ist vorzugsweise als Regelstrecke seines Regelkreises ausgebildet, wobei insbesondere die Drain-Source-Spannung bzw. Kollektor-Emitter-Spannung über dem Widerstandelement die Regelgröße bildet und die Gate-Source-Spannung bzw. Basis-Emitter-Spannung an dem Widerstandelement die Stellgröße, aus welcher direkt oder indirekt der Messstrom bzw. der Wert des Stroms durch das Widerstandelements berechnet wird.

Es ist bevorzugt, dass die Drain-Source-Spannung bzw. Kollektor-Emitter-Spannung über dem wenigstens einen Transistorelement, als das zumindest eine Widerstandelement, von mindestens einem Regelkreis auf einen konstanten, durch eine Referenzspannungsquelle bestimmten Wert, eingeregelt wird, unabhängig vom Strom, der durch das Widerstandelement fließt. Das heißt, das Widerstandelement arbeitet als geregelter Widerstand.

Außerdem bezieht sich die Erfindung auch auf die Verwendung des Stromsensors in Kraftfahrzeugen, insbesondere zur Messung eines Ent- und/oder Aufladestroms eines elektrischen Energiespeichers in einem Elektro- oder Hybridfahrzeug.

Weitere bevorzugte Ausführungsformen ergeben sich aus den Unteransprüchen und den nachfolgenden Beschreibungen von Ausführungsbeispielen an Hand von Figuren.

Es zeigen in schematischer Darstellung

Fig. 1   ein Ausführungsführungsbeispiel des Stromsensors zur Messung des Lade- und Entladestroms einer Batterie,

Fig. 2   einen beispielhaften Stromsensor mit zwei Regelkreisen, jeweils umfassend ein Widerstandelement, welchem ein SenseFET zugeordnet ist,

Fig. 3   eine beispielhafte Veranschaulichung des Regelkreises des Stromsensors, und

Fig. 4   ein Ausführungsbeispiel, bei welchem das Widerstandelement parallel geschaltete und dabei zu- und abschaltbare Teilwiderstandelemente umfasst zur Messbereichserweiterung.

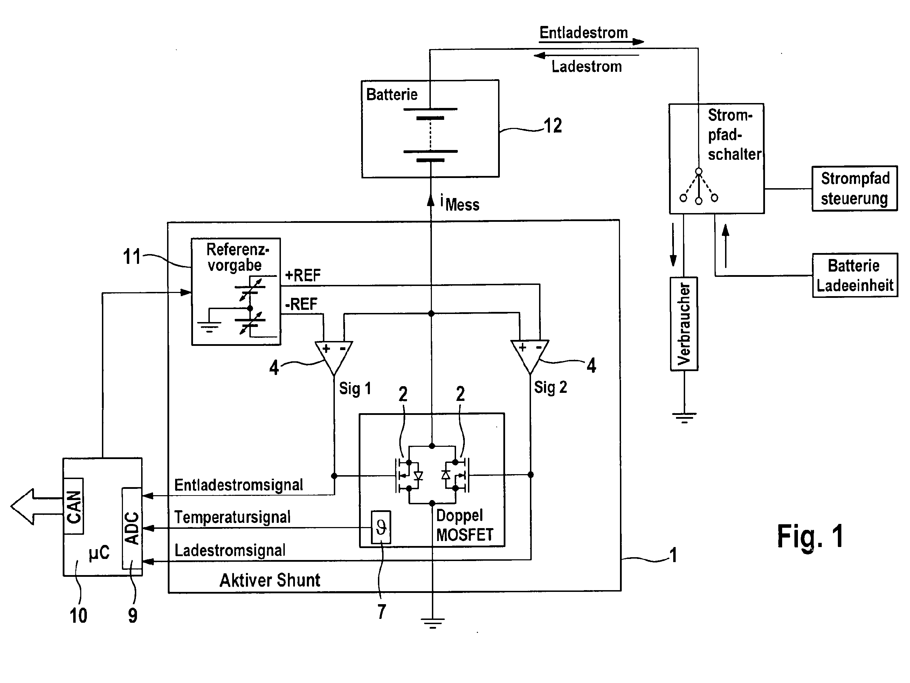

Fig. 1 zeigt ein Ausführungsbeispiel des Stromsensors 1, der zur Messung des Entlade- und Ladestroms $i_{Mess}$ eines elektrischen Energiespeichers bzw. Batterie 12 benutzt wird. Stromsensor 1 umfasst dabei einen ersten und einen zweiten Regelkreis, wobei der erste Regelkreis das linke Widerstandelement 2, den linken Verstärker 4 bzw. Sig1 sowie die diesem zugeordnete Referenzspannungswertvorgabe der Referenzspannungsquelle 11 umfasst, und der zweite Regelkreis das rechte Widerstandselement 2, den rechten Verstärker 4 bzw. Sig2 und die entsprechende Referenzspannungswertvorgabe umfasst. Die beiden Widerstandselemente der beiden Regelkreise werden von dem zum messenden Strom $i_{Mess}$ durchflossen, wobei das Widerstandselement des ersten Regelkreises beim Entladen von Stromdurchflossen wird und das Widerstandselement des zweiten Regelkreises beim Laden, also wenn Messstrom $i_{Mess}$ die entgegengesetzte Fließrichtung aufweist. Die Widerstandselemente 2 des ersten und zweiten Regelkreises sind beispielgemäß als zwei zueinander komplementär ausgebildete MOS-Feldeffekttransistoren ausgebildet und parallel geschaltet, wobei der Drainanschluss des einen Widerstandselements jeweils mit dem Sourceanschluss des anderen Widerstandselements wechselseitig verbunden ist. Die Drain-Source-Spannung der beiden MosFETs wird dabei auf einen definierten Referenzspannungswert eingeregelt, wodurch der Widerstandswert der beiden Widerstandselemente im Wesentlichen abhängig von 1 durch den Wert des Stroms $i_{Mess}$ durch das Widerstandselement ausgeprägt ist und somit bei steigendem Messstrom $i_{Mess}$ der Widerstandswert abnimmt und bei abnehmendem Strom der Widerstandswert der Widerstandselement 2 zunimmt. Zur Messung des Stroms wird dabei die Gate-Source-Spannung des entsprechenden Widerstandselements erfasst, welche die Stellgröße des ersten und zweiten Regelkreises ist und dem Analog-Digital-Wandler 9 zugeführt wird. Stromsensor1 weist außerdem ein Temperaturmesselement 7 auf, das die Temperatur $\vartheta$ der bei den Widerstandselemente 2 erfasst, wobei diese Temperatur bei der Berechnung des Messstroms in der Signalverarbeitungseinheit 10 berücksichtigt wird. Die zu regelnde Drain-Source-Spannung liegt jeweils weit unter der Flussspannung der parasitären Dioden, bei einigen mV. Die Berücksichtigung der Temperaturabhängigkeit der Transistorkennlinien erfolgt durch Messen der Transistortemperatur und anschließender Temperaturkompensation der Rohdaten.

Die Vorteile sind hier unter anderem:

- Es wird mit erheblich höheren Spannungen gearbeitet, beispielsweise mehr als 100mV bis einige Volt, als an einem Shunt, Spannungen im $\mu$V-Bereich, was eine wesentlich höhere EMV-Festigkeit zur Folge hat.
- Es muss kein Spezial IC zur Messwertaufnahme verwendet werden, d.h. es können Standardmikrokontroller als Signalverarbeitungseinheit 10 mit integriertem AD-Wandler 9 verwendet werden, was die Kosten gering hält.

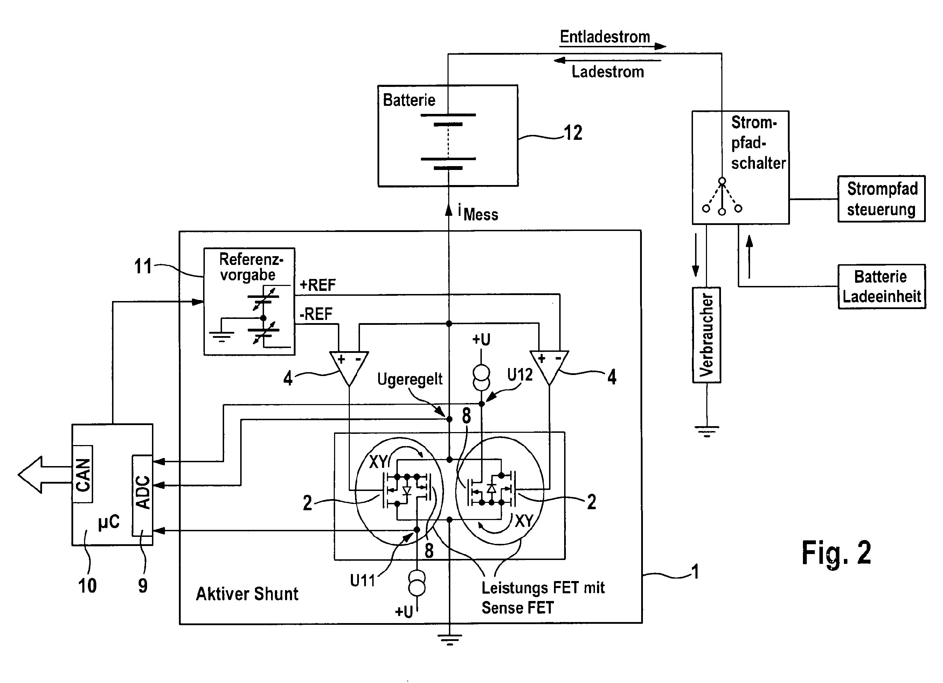

In Fig. 2 ist ein Ausführungsbeispiel veranschaulicht, das ausgehend vom Stromsensor aus Fig.1 den MosFET-Widerstandselementen der beiden Regelkreise jeweils einen zugeordneten SenseFET 8 umfasst. Also beiden LeistungsFETs als Widerstandselemente 2 ist noch jeweils ein SENSE-FET zugeordnet, welcher mit Analog-Digital-Wandler 9 verbunden ist, wobei mittels des SenseFETs der Strom durch das Widerstandselement 2 bestimmt wird. Die Gate-Source-Spannung des SenseFETs ist jeweils gleich der Gate-Source-Spannung des zugeordneten Widerstandselements bzw. LeistungsFETs ausgeprägt. Der Quotient aus dem Wert des Drain-Source-Widerstands des SenseFETs zu dem Wert des Drain-Source-Widerstands des zugeordneten Widerstandselements weist einen definierten Wert X/Y auf. Dieser Wert X/Y kann dabei für jeden Pfad unterschiedlich sein (X1/Y1 - X2/Y2). Das Verhältnis dieser beiden Widerstandswerte bzw. -wertepaare ist nahezu temperaturunabhängig und lässt sich sehr genau herstellen. Die beiden SENSE-FETs werden über zwei getrennte Stromquellen mit einem stabilen, präzisen Strom beaufschlagt. Misst man nun die Spannungen U11 bzw. U12 und dividiert diese durch den bekannten Strom der Stromquellen, so erhält man den eingeregelten Widerstandswert der Leistungs FETs dividiert durch den Teilungsfaktor X/Y. Durch Multiplikation mit der gemessenen Spannung Ugeregelt erhält man den Strom $i_{Mess}$, der durch die LeistungsFETs bzw. Widerstandselemente 2 fließt.

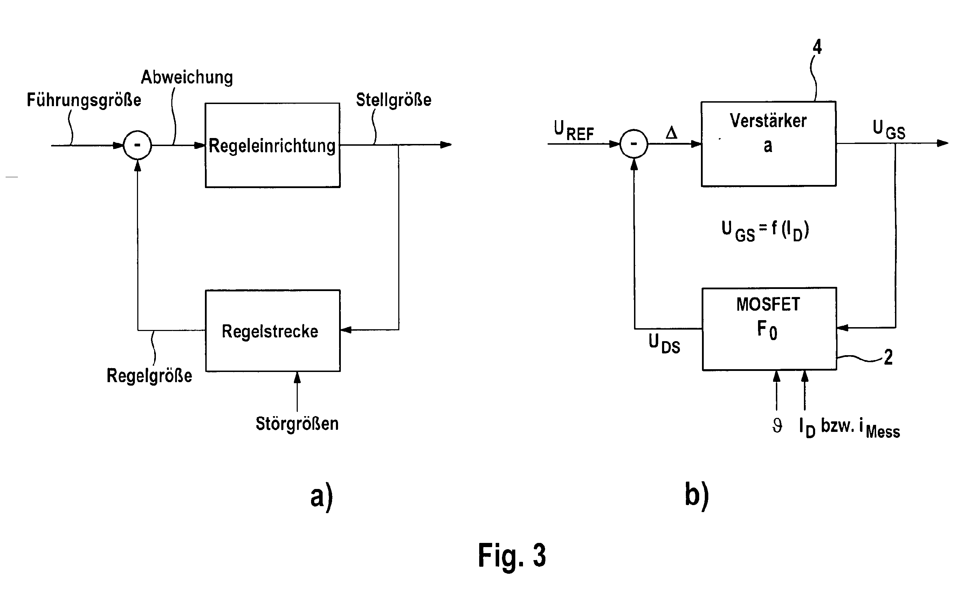

Fig. 3 a) zeigt einen schematischen Regelkreis, dem gegenübergestellt anhand der Fig. 3 b) ein beispielhafter Regelkreis des Stromsensors erläutert wird. Der Referenzspannungswert $U_{REF}$ ist die Führungsgröße. In Verstärker 4, der als Reglereinheit und Stelleinrichtung ausgebildet ist, wird die Stellgröße $U_{GS}$ als Gate-Source-Spannung bereitgestellt, die über dem Widerstandselement anliegend eingeregelt wird. Das Widerstandselement 2 selbst bildet die Regelstrecke, welche durch den Messstrom $i_{Mess}$ sowie die Temperatur $\vartheta$ beeinflusst wird. Aus der Regelgröße $U_{DS}$ als Drain-Source-Spannung des Widerstandselements wird Messstrom $i_{Mess}$ berechnet.

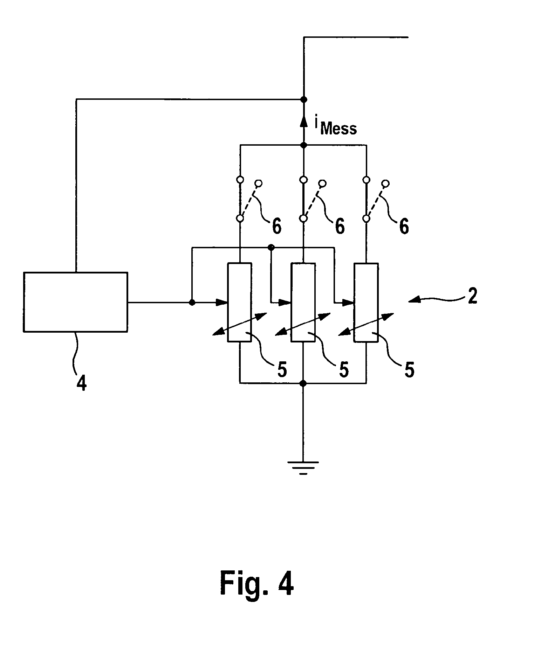

Anhand der Fig. 4 ist eine Ausführungsform veranschaulicht, bei der Widerstandselement 2 drei parallel geschaltete Teilwiderstandselemente 5 umfasst, welche durch Schalter 6 zu- und abschaltbar ausgebildet sind zur Messbereichserweiterung. Die Teilwiderstandselemente 5 werden von Verstärker 4, als Reglereinheit und Stelleinrichtung, angesteuert.

## Patentansprüche

1. Stromsensor (1), umfassend wenigstens ein Widerstandselement (2), an welchem eine Spannung ($U_{GS}$) zur Messung des durch das Widerstandselement (2) fließenden Stroms ($i_{Meas}$) erfasst wird, wobei
   das Widerstandselement (2) so ausgebildet ist, dass zumindest innerhalb eines definierten Messbereichs des Stromsensors der elektrische Widerstand des Widerstandselements abnimmt, wenn der Strom ($i_{Mess}$) durch das Widerstandselement zunimmt,

**dadurch gekennzeichnet, dass**

dieser so ausgebildet ist, dass die prozentuale Auflösung der Strommessung bezogen auf den aktuellen Wert des Stroms ($i_{Mess}$) durch das Widerstandselement (2) über den definierten Messbereich des Stromsensors (1) im Wesentlichen konstant bleibt, wobei der Stromsensor eingerichtet ist, dass die Auflösung von delta/deltaBit mal einem Proportionalitätsfaktor immer kleiner ist als der maximale Messfehler e, wobei delta die Änderung des zu messenden Stroms durch das wenigstens eine Widerstandselement und deltaBit das Messauflösungsquantum definiert durch einen nachgeschalteten Analog-Digital-Wandler ist.

2. Stromsensor nach Anspruch 1, **dadurch gekennzeichnet, dass** dieser mindestens einen Regelkreis (2, 4) umfasst, mit welchem die Spannung ($U_{DS}$) über dem Widerstandselement (2) auf einen definierten Referenzspannungswert eingeregelt wird, zumindest innerhalb eines definierten Messbereichs.

3. Stromsensor nach Anspruch 1 oder 2, **dadurch gekennzeichnet, dass** der definierte Referenzspannungswert mindestens 1 mV beträgt.

4. Stromsensor nach Anspruch 2 oder 3, **dadurch gekennzeichnet, dass** dieser so ausgebildet ist, dass die definierte Referenzspannung zur Messbereichserweiterung einstellbar ist.

5. Stromsensor nach mindestens einem der Ansprüche 1 bis 4, **dadurch gekennzeichnet, dass** das Widerstandselement (2) ein Transistorelement, insbesondere einen Feld-Effekt-Transistor, umfasst.

6. Stromsensor nach Anspruch 5, **dadurch gekennzeichnet, dass** die Spannung ($U_{GS}$) zur Messung des durch das Widerstandselement fließenden Stroms als Gate-Source-Spannung oder Basis-Emitter-Spannung an dem Transistorelement (2) erfasst wird.

7. Stromsensor nach mindestens einem der Ansprüche 1 bis 6, **dadurch gekennzeichnet, dass** der definierte Messbereich des Messstroms ($i_{Mess}$) ein Messintervall von mindestens vier Zehnerpotenzen, insbesondere mindestens fünf Zehnerpotenzen, umfasst.

8. Stromsensor nach mindestens einem der Ansprüche 2 bis 7, **dadurch gekennzeichnet, dass** bei geregelter Spannung ($U_{DS}$) über dem Widerstandselement (2) der Widerstandswert des Widerstandselements im Wesentlichen abhängig ist von 1 durch den Wert des Stroms ($i_{Mess}$) durch das Widerstandselement oder im Wesentlichen abhängig ist von 1 durch die Wurzel aus dem Wert des Stroms ($i_{Mess}$) durch das Widerstandselement.

9. Stromsensor nach mindestens einem der Ansprüche 1 bis 8, **dadurch gekennzeichnet, dass** das wenigstens eine Widerstandselement (2) zwei oder mehr parallel geschaltete Teilwiderstandselemente (5) umfasst, welche zu- und/oder abschaltbar (6) ausgebildet sind im Wesentlichen zur Messbereichserweiterung.

10. Stromsensor nach mindestens einem der Ansprüche 1 bis 9, **dadurch gekennzeichnet, dass** dieser zumindest ein Temperaturmesselement (7) aufweist, welches die Temperatur ($\vartheta$) des wenigstens einen Widerstandselements (2) erfasst, wobei diese Temperatur bei der Messung des durch das mindestens eine Widerstandselement fließenden Stroms ($i_{Mess}$) berücksichtigt wird, insbesondere durch eine Berechnung in wenigstens einer Signalverarbeitungseinheit (10) des Stromsensors.

11. Stromsensor nach mindestens einem der Ansprüche 2 bis 10, **dadurch gekennzeichnet, dass** dieser einen ersten und einen zweiten Regelkreis umfasst, mit welchen jeweils die Spannung ($U_{DS}$) über einem Widerstandselement (2) auf einen definierten Referenzspannungswert eingeregelt wird, zumindest innerhalb eines definierten Messbereichs, wobei das Widerstandselement des ersten Regelkreises von dem zu messenden Strom mit einer ersten definierten Richtung durchflossen werden kann und das Widerstandselement des zweiten Regelkreises von dem zu messenden Strom mit einer zweiten, zur ersten Richtung entgegengesetzten Richtung durchflossen werden kann und der zu messende Strom je nach Stromrichtung mittels des ersten Regelkreises oder mittels des zweiten Regelkreises erfasst und gemessen wird.

12. Stromsensor nach Anspruch 11, **dadurch gekennzeichnet, dass** die Widerstandselemente des ersten und zweiten Regelkreises als zwei zueinander komplementär ausgebildete Feldeffekttransistoren ausgebildet sind und/oder dass die Widerstandselemente des ersten und zweiten Regelkreises parallel geschaltet sind und dabei der Drainanschluss oder Kollektoranschluss des einen Widerstandselements jeweils mit dem Sourceanschluss oder Emitteranschluss des anderen Widerstandselements verbunden ist, insbesondere wechselseitig.

13. Stromsensor nach mindestens einem der Ansprüche 1 bis 12, **dadurch gekennzeichnet, dass** dem wenigstens einen Widerstandselement (2) zumindest ein SenseFET (8) zugeordnet ist, welcher mit einem Analog-Digital-Wandler (9) verbunden ist, wobei mittels des SenseFETs (8) der Strom ($i_{Mess}$) durch das Widerstandselement (2) bestimmt wird.

14. Verwendung des Stromsensors nach mindestens einem der Ansprüche 1 bis 13 in Kraftfahrzeugen, insbesondere zur Messung eines Ent- und/oder Aufladestroms eines elektrischen Energiespeichers (12) in einem Elektro- oder Hybridfahrzeug.

**Claims**

1. Current sensor (1), comprising at least one resistance element (2), to which a voltage ($U_{GS}$) for measuring the current ($i_{Meas}$) flowing through the resistance element (2) is detected, wherein the resistance element (2) is designed such that, at least within a defined measurement range of the current sensor, the electrical resistance of the resistance element decreases if the current ($i_{Meas}$) through the resistance element increases, **characterized in that** said current sensor is designed such that the percentage resolution of the current measurement relative to the present value of the current ($i_{Meas}$) through the resistance element (2) remains substantially constant over the defined measurement range of the current sensor (1), wherein the current sensor is designed such that the resolution of deltaI/deltaBit times a proportionality factor is always less than the maximum measurement error e, wherein deltaI is the change in the current to be measured through the at least one resistance element and deltaBit is the measurement resolution quantum defined by an analog-to-digital converter connected downstream.

2. Current sensor according to Claim 1, **characterized in that** said current sensor comprises at least one closed-loop control circuit (2, 4) which is used to adjust the voltage ($U_{DS}$) across the resistance element (2) to a defined reference voltage value, at least within a defined measurement range.

3. Current sensor according to Claim 1 or 2, **characterized in that** the defined reference voltage value is at least 1 mV.

4. Current sensor according to Claim 2 or 3, **characterized in that** said current sensor is designed such that the defined reference voltage is adjustable for extending the measurement range.

5. Current sensor according to at least one of Claims 1 to 4, **characterized in that** the resistance element (2) comprises a transistor element, in particular a field effect transistor.

6. Current sensor according to Claim 5, **characterized in that** the voltage ($U_{GS}$) for measuring the current flowing through the resistance element is detected as gate-source voltage or base-emitter voltage at the transistor element (2).

7. Current sensor according to at least one of Claims 1 to 6, **characterized in that** the defined measurement range of the measurement current ($i_{Meas}$) comprises a measurement interval of at least four powers of ten, in particular at least five powers of ten.

8. Current sensor according to at least one of Claims 2 to 7, **characterized in that**, with voltage ($U_{DS}$) across the resistance element (2) controlled by closed-loop control, the resistance value of the resistance element is substantially dependent on 1 divided by the value of the current ($i_{Meas}$) through the resistance element or is substantially dependent on 1 divided by the root of the value of the current ($i_{Meas}$) through the resistance element.

9. Current sensor according to at least one of Claims 1 to 8, **characterized in that** the at least one resistance element (2) comprises two or more parallelconnected partial resistance elements (5) which are designed such that they can be switched (6) in and/or out, substantially for extending the measurement range.

10. Current sensor according to at least one of Claims 1 to 9, **characterized in that** said current sensor has at least one temperature measuring element (7) which detects the temperature (9) of the at least one resistance element (2), wherein said temperature is taken into account during the measurement of the current ($i_{Meas}$) flowing through the at least one resistance element, in particular by a calculation in at least one signal processing unit (10) of the current sensor.

11. Current sensor according to at least one of Claims 2 to 10, **characterized in that** said current sensor comprises a first and a second closed-loop control circuit, which are used in each case to adjust the voltage ($U_{DS}$) across a resistance element (2) to a defined reference voltage value, at least within a defined measurement range, wherein the current to be measured can flow with a first defined direction through the resistance element of the first closed-loop control circuit and the current to be measured can flow with a second direction, opposite to the first direction, through the resistance element of the second closed-loop control circuit, and the current to be measured is detected and measured by means of the first closed-loop control circuit or by means of the second closed-loop control circuit, depending on the current direction.

12. Current sensor according to Claim 11, **characterized in that** the resistance elements of the first and second closed-loop control circuits are designed as two field effect transistors designed complementarily to one another, and/or **in that** the resistance elements of the first and second closed-loop control circuits are connected in parallel and in this case the drain terminal or collector terminal of one resistance element is respectively connected to the source terminal or emitter terminal of the other resistance element, in particular reciprocally.

13. Current sensor according to at least one of Claims 1 to 12, **characterized in that** the at least one resistance element (2) is assigned at least one senseFET (8) connected to an analog-to-digital converter (9), wherein the current ($i_{Meas}$) through the resistance element (2) is determined by means of the senseFET (8).

14. Use of the current sensor according to at least one of Claims 1 to 13 in emitter vehicles, in particular for measuring a discharge and/or charging current of an electrical energy store (12) in an electric or hybrid vehicle.

**Revendications**

1. Détecteur de courant (1), comprenant au moins un élément résistif (2) au niveau duquel est détectée une tension ($U_{GS}$) servant à mesurer le courant ($i_{Mess}$) qui circule à travers l'élément résistif (2),
l'élément résistif (2) étant configuré de telle sorte que la résistance électrique de l'élément résistif diminue au moins à l'intérieur d'une plage de mesure définie du détecteur de courant lorsque le courant ($i_{Mess}$) à travers l'élément résistif augmente,
**caractérisé en ce que**
celui-ci est configuré de telle sorte que la résolution en pourcentage de la mesure du courant rapportée à la valeur actuelle du courant ($i_{Mess}$) à travers l'élément résistif (2) demeure sensiblement constante sur la plage de mesure définie du détecteur de courant (1), le détecteur de courant étant configuré de telle sorte que la résolution de deltaI/deltaBit multipliée par un facteur de proportionnalité est toujours inférieure à l'erreur de mesure e maximale, deltaI désignant la modification du courant à mesurer à travers l'au moins un élément résistif et deltaBit désignant la quantité de résolution de mesure définie par un convertisseur analogique/numérique branché en aval.

2. Détecteur de courant selon la revendication 1, **caractérisé en ce que** celui-ci comprend au moins un circuit de régulation (2, 4) avec lequel la tension ($U_{DS}$) aux bornes de l'élément résistif (2) est régulée à une valeur de tension de référence définie, au moins à l'intérieur d'une plage de mesure définie.

3. Détecteur de courant selon la revendication 1 ou 2, **caractérisé en ce que** la valeur de tension de référence définie est au moins égale à 1 mV.

4. Détecteur de courant selon la revendication 2 ou 3, **caractérisé en ce que** celui-ci est configuré de telle sorte que la tension de référence définie est réglable en vue d'élargir la plage de mesure.

5. Détecteur de courant selon au moins l'une des revendications 1 à 4, **caractérisé en ce que** l'élément résistif (2) comprend un élément à transistor, notamment un transistor à effet de champ.

6. Détecteur de courant selon la revendication 5, **caractérisé en ce que** la tension ($U_{GS}$) servant à mesurer le courant qui circule à travers l'élément résistif est détectée en tant que tension gâchette/source ou tension base/émetteur au niveau de l'élément à transistor (2).

7. Détecteur de courant selon au moins l'une des revendications 1 à 6, **caractérisé en ce que** la plage de mesure définie du courant de mesure ($i_{Mess}$) comprend un intervalle de mesure d'au moins quatre puissances de dix, notamment d'au moins cinq puissances de dix.

8. Détecteur de courant selon au moins l'une des revendications 2 à 7, **caractérisé en ce qu'**en présence d'une tension ($U_{DS}$) régulée aux bornes de l'élément résistif (2), la valeur de la résistance de l'élément résistif est sensiblement dépendante de 1 par la valeur du courant ($i_{Mess}$) à travers l'élément résistif ou est sensiblement dépendante de 1 par la racine de la valeur du courant ($i_{Mess}$) à travers l'élément résistif.

9. Détecteur de courant selon au moins l'une des revendications 1 à 8, **caractérisé en ce que** l'au moins un élément résistif (2) comprend deux éléments résistifs partiels (5) ou plus branchés en parallèle, lesquels sont configurés pour pouvoir être mis en circuit et/ou hors circuit (6) sensiblement en vue d'élargir la plage de mesure.

10. Détecteur de courant selon au moins l'une des revendications 1 à 9, **caractérisé en ce que** celui-ci possède au moins un élément de mesure de la température (7) qui détecte la température (9) de l'au moins un élément résistif (2), cette température étant prise en compte lors de la mesure du courant ($i_{Mess}$) qui circule à travers l'au moins un élément résistif, notamment par un calcul dans au moins une unité de traitement de signal (10) du détecteur de courant.

11. Détecteur de courant selon au moins l'une des revendications 2 à 10, **caractérisé en ce que** celui-ci comprend un premier et un deuxième circuit de régulation avec lesquels la tension ($U_{DS}$) aux bornes d'un élément résistif (2) est respectivement régulée à une valeur de tension de référence définie, au moins à l'intérieur d'une plage de mesure définie, l'élément résistif du premier circuit de régulation pouvant être traversé par le courant à mesurer dans une première direction définie et l'élément résistif du deuxième circuit de régulation pouvant être traversé par le courant à mesurer dans une deuxième direction opposée à la première direction, et le courant à mesurer étant détecté et mesuré au moyen du premier circuit de régulation ou au moyen du deuxième circuit de régulation, suivant la direction du courant.

12. Détecteur de courant selon la revendication 11, **caractérisé en ce que** les éléments résistifs du premier et du deuxième circuit de régulation sont réalisés sous la forme de deux transistors à effet de champ mutuellement complémentaires et/ou **en ce que** les éléments résistifs du premier et du deuxième circuit de régulation sont branchés en parallèle et la borne de drain ou la borne de collecteur de l'un des éléments résistifs est en l'occurrence respectivement connectée à la borne de source ou la borne d'émetteur de l'autre élément résistif, notamment en alternance.

13. Détecteur de courant selon au moins l'une des revendications 1 à 12, **caractérisé en ce qu'**au moins un SenseFET (8) est associé à l'au moins un élément résistif (2), lequel est relié à un convertisseur analogique/numérique (9), le courant ($i_{Mess}$) à travers l'élément résistif (2) étant déterminé au moyen du SenseFET (8).

14. Utilisation du détecteur de courant selon au moins l'une des revendications 1 à 13 dans des véhicules automobiles, notamment pour mesurer un courant de décharge et/ou de charge d'un accumulateur d'énergie électrique (12) dans un véhicule électrique ou hybride.

Fig. 1

Fig. 2

EP 2 588 869 B1

EP 2 588 869 B1

Abweichung

Führungsgröße
Stellgröße

Regeleinrichtung

Regelstrecke

Regelgröße

Störgrößen

a)

$U_{REF}$
$\Delta$
4

Verstärker
a
$U_{GS}$

$U_{GS} = f(I_D)$

MOSFET
$F_0$

$U_{DS}$

2

$\vartheta$  $I_D$ bzw. $i_{Mess}$

b)

**Fig. 3**

$i_{Mess}$

6   6   6

2

5   5   5

4

# Fig. 4

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- WO 2008071722 A
- US 2006250153 A
- DE 10223977 C1